# EUROPEAN PATENT SPECIFICATION

(11) **EP 0 482 927 B1**
(45) Date of publication and mention of the grant of the patent: **31.05.1995**
(21) Application number: 91309839.8
(22) Date of filing: 24.10.1991
(51) Int. Cl.: H04B 1/30

(54) **Digital radio receiver**
Digitaler Funkempfänger
Récepteur radio numérique

(30) Priority: 25.10.1990 JP 285750/90
(43) Date of publication of application: 29.04.1992
(73) Proprietor: NEC CORPORATION, Tokyo (JP)
(72) Inventor: Ichihara, Masaki, c/o NEC Corporation, Minato-ku, Tokyo (JP)
(74) Representative: Abnett, Richard Charles

(56) References cited:
- EP-A- 0 395 368
- FR-A- 2 341 981
- GB-A- 2 179 810
- "High bit-rate digital mobile radio transmission with a decision feedback
- equalizser." Suzuki et al. BOSTON ICC 11-14 June 1989 IEEE InternationalConference on Communications.

## Description

The present invention relates generally to digital radio communications systems, and more specifically to a digital radio receiver for mobile communications systems in which the receiver suffers from multipath fading and interference.

In digital mobile radio, orthogonal modulation techniques are employed for conveying TDM (time division multiplex) signals. To overcome bit errors caused by multipath fading and interference, maximum likelihood sequence estimation technique is known. A known digital radio receiver includes a linear amplifier for linearly amplifying IF (intermediate frequency) input signal to produce an output X · cos (2πf_{c} + ϑt), where X is the amplitude of the lF input and f_{c} is the carrier frequency. An orthogonal detector provides mixing of the amplifier output with a local carrier A · cos 2πf_{c} for detecting the in-phase baseband component (I = aX · cos ϑt) and the quadrature-phase baseband component (Q = aX · sin ϑt) of the transmitted signal, where A is the amplitude of the local carrier, where a is a constant and the phase component ϑt contains the information to be conveyed. After conversion to digitaI form, the l and Q signals are fed into a digital demodulator to recover the transmitted information using the MLSE adaptive equalization technique. In the adaptive equalization process the amplitude component 'aX' provides useful information for eliminating bit errors caused by multipath fading and interference. However, with mobile radio the amplitude component 'aX' varies significantly with the length of signal propagation path as well as with variations charateristic of the individual path, giving a variation range of 80 dB in a worst condition. Because of the wide dynamic range, the amplitude components 'aX' of the baseband signals cannot properly be represented by digital signals of a practical bit length. Although the long-term variations of the l and Q signals may be significantly compressed by the use of an AGC (automatic gain controlled) amplifier, instead of the linear lF amplifier, by appropriately proportioning the AGC time constants, the short-term variations are passed through the AGC amplifier and produce quantum noise.

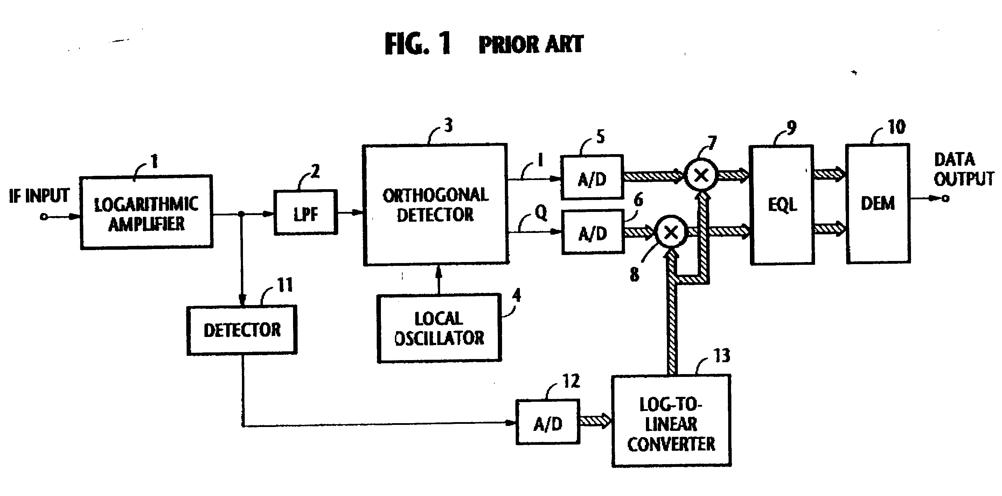

In order to reduce errors caused by the multipath fading and quantum noise, a digital radio receiver as shown in Fig. 1 has been proposed. According to this prior art, the dynamic range of lF signal is compressed by the use of a logarithmic amplifier 1. A low-pass filter 2 is provided for removing harmonic components that are produced as a result of the nonlinear amplification. The filtered signal is applied to an orthogonal detector 3 in which it is mixed with the local carrier from oscillator 4 to produce an in-phase baseband signal (I = a · log X · cos ϑt) and a quadrature phase signal (Q = a · log X · sin ϑt), which are converted to digital signals by A/D converters 5 and 6 and fed into multipliers 7 and 8. On the other hand, a detector 11 is coupled to the output of amplifier 1 to produce a DC signal representative of the amplitude of the lF signal. After conversion to digital form by A/D converter 12, the logarithmic scale of the DC signal is converted to a linear scale by a logarithmic-to-linear converter 13 and applied to multipliers 7 and 8 in which the l and Q signals are modified linearly with the amplitude signal. The outputs of multipliers 7 and 8 are coupled to an MLSE equalizer 9 to equalize the multiple propagation paths. The equalized signals are fed into a demodulator 10 to produce a replica of the original digital signal.

Since the logarithmic amplifier is not ideal from the view point of amplitude compression, each of the l and Q signals contains the amplitude component of the IF signal at the inputs of multipliers 7 and 8, and the multiplication process generates outputs containing a product component of the amplitude representative signals. Thus, the input signals of the equalizer differ from what is desired for equalization.

### SUMMARY OF THE INVENTION

It is therefore an object of the present invention to provide digital demodulation of orthogonal digital baseband signals without introducing components undesirable for eliminating errors caused by multipath fading and interference.

According to the present invention, an amplitude limiter circuit is included for maintaining the amplitude of a received digitally modulated signal at a constant value. An orthogonal detector provides orthogonal mixing of the constant-amplitude signal with a reference carrier and produces a first baseband signal in phase with the reference carrier and a second baseband signal in quadrature phase with the reference carrier. The first and second baseband signals are converted to first and second digital signals, respectively, and supplied to multipliers. A logarithmic detector circuit is coupled to the amplitude limiter for producing a signal representative of the amplitude of the modulated signal. A logarithmic-to-linear converter circuit is coupled to the logarithmic detector for converting the logarithmic scale of the amplitude representative signal to linear scale. The first and second digital signals are multiplied with the linear-scale amplitude representative signal and supplied to a digital equalizer for eliminating bit errors arising from multipath fading and interference. To the output of the equalizer is connected a digital demodulator for producing a replica of the modulating signal.

In a preferred embodiment, the amplitude limiter circuit comprises a series of tapped limiter amplifiers for defining successive tap points, and the logarithmic detector comprises a plurality of detectors coupled respectively to the tap points of the amplitude limiter and an adder for summing the outputs of the detectors to produce the amplitude representative signal.

### BRIEF DESCRIPTION OF THE DRAWINGS

The present invention will be described in further detail with reference to the accompanying drawings, in which:
Fig. 1 is a block diagram of a prior art digital radio receiver;
Fig. 2 is a block diagram of a digital radio receiver according to the present invention; and
Fig. 3 is a circuit diagram illustrating details of the amplitude limiter and logarithmic detector of Fig. 2.

### DETAILED DESCRIPTION

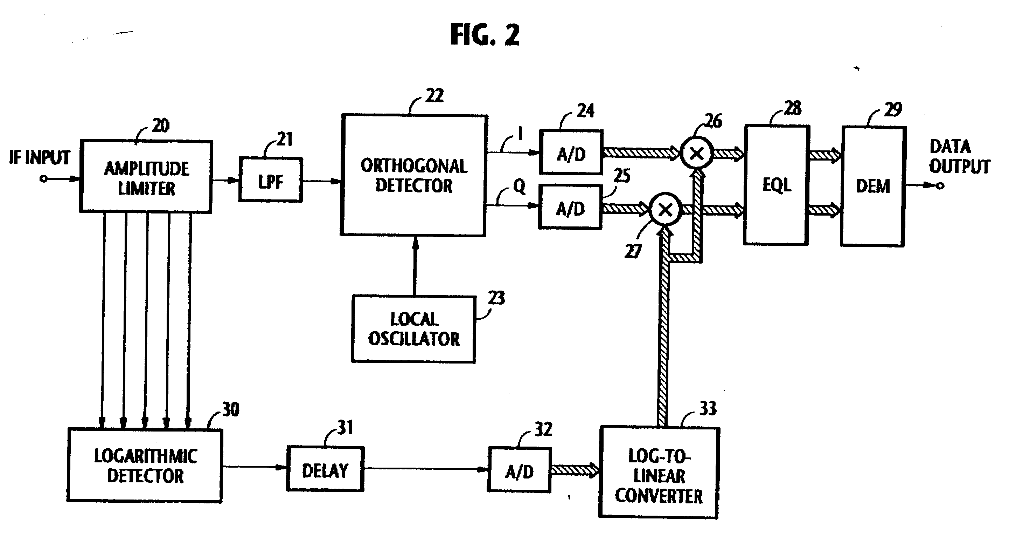

Referring now to Fig. 2, there is shown a digital radio receiver according to present invention. The receiver comprises an amplitude limiter 20 for limiting the amplitude varying range of an lF Input signal and producing a constant-amplitude signal for coupling to a low-pass filter 21 to remove harmonic components produced as a result of the nonlinear relationship between the input and output of amplitude limiter 20. The output of filter 21 is fed into an orthogonal detector 22 in which it is mixed with a local carrier supplied from oscillator 23 to produce an l signal (l = a · cos ϑt) and a Q signal (Q = a · sin ϑt). These baseband signals are converted to digital form by A/D converters 24 and 25, the outputs of which are coupled to multipliers 26 and 27, respectively. An MLSE equalizer 28 is coupled to the output of multipliers 26, 27 to produce equalized l and Q signals for coupling to a demodulator 29.

Since both l and Q signals contain no race of the amplitude component 'X' mentioned previously, they are applied to A/D converters 24 and 25 at an optimum level by appropriately determining the integer 'a'. A logarithmic detector 30 is connected to the amplitude limiter 20 to logarithmically detect the lF signal and produce a DC signal indicative of the amplitude of the lF input signal. The DC output of logarithmic detector 30 is coupled to a delay circuit 31 so that its output signal is synchronized with the l and Q signals. The delayed signal is applied to an A/D converter 32 and converted to digital form and applied to a logarithmic-to-linear converter 33 in which the logarithmic scale of the amplitude representative signal is converted to a linear scale and applied to multipliers 26 and 27 in which they are multiplied with the digital l and Q signals. Since in consequence of the amplitude limiting action of limiter 20, no trace of amplitude component of the lF signal is contained in the l and Q baseband signal, the outputs of multipliers 26 and 27 contain no components other than those useful for equalization.

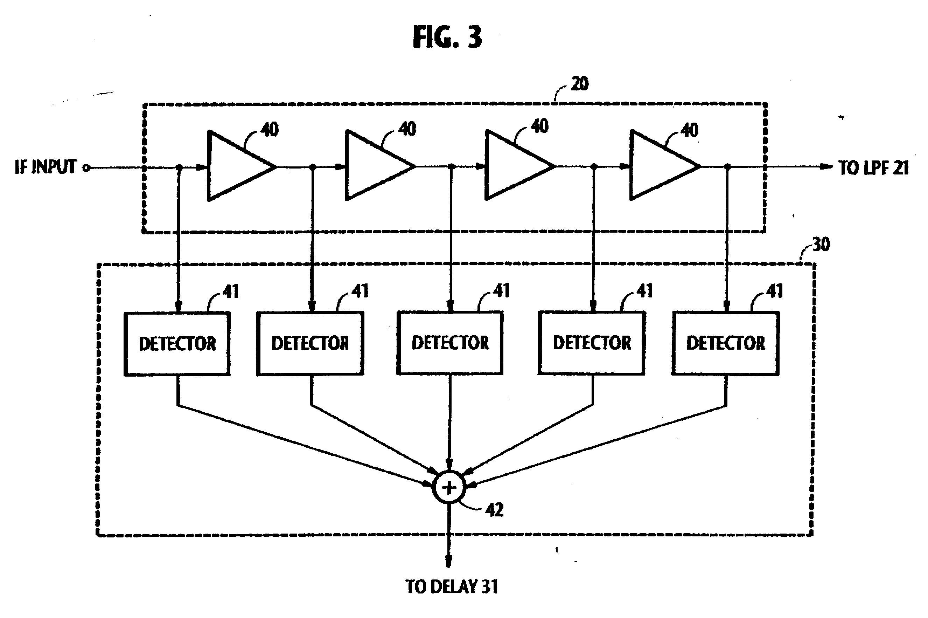

A preferred form of the amplitude limiter 20 and logarithmic detector 30 is shown in Fig. 3. As illustrated, the amplitude limiter 20 comprises a plurality of limiter amplifiers 40. Amplifiers 40 are series-connected to form successive tap points between the lF input terminal and the input of low-pass filter 21. The logarithmic detector 30 comprises a plurality of detectors 41 connected respectively to the tap points of amplitude limiter 20. The outputs of detectors 41 are summed by an adder 42 to produce the amplitude representative signal for coupling to delay circuit 31. Each of the limiting amplifiers 40 has an amplification gain of 10 dB so that the dynamic range of the lF signal is determined by the product of the value of 10-dB and the number of the limiting amplifier stages. For a given dynamic range of the lF input signal, the resolution of the amplitude representative signal increases with respect to the logarithmic amplitude as a function of the number of limiter stages with a decreasing value of amplification gain.

## Claims

1. A digital radio receiver comprising:
means (20, 21) for receiving an orthogonally modulated signal (IF) and producing a modified version of the received signal;
orthogonal detector means (22) coupled to the receiving means for orthogonally mixing the modified signal with a reference carrier and producing a first baseband signal (I) in phase with the reference carrier and a second baseband signal (Q) in phase quadrature with the reference carrier;
analog-to-digital converter means (24, 25) for converting the said first and second baseband signals to first and second digital baseband signals, respectively;
logarithmic-to-linear converter means (33) coupled to the receiving means for converting logarithmic scale to linear scale;
multiplier means (26, 27) for multiplying the first and second digital baseband signals with the linear-scale amplitude representative signal from the logarithmic-to-linear converter means;
equaliser means (28) coupled to the multiplier means for equalizing the multiplied first and second digital baseband signals to produce first and second equalized digital signals; and
demodulator means (29) coupled to the equalizer means for recovering a modulating signal from the first and second equalized digital signals;
characterized in that the receiving means comprises amplitude limiter means (20, 21) for receiving the orthogonally modulated signal (IF) and producing a constant amplitude version of the received signal, in that the orthogonal detector means (22) is coupled to the amplitude limiter means for orthogonally mixing the constant amplitude signal with the reference carrier, and by logarithmic detector means (30) coupled between the amplitude limiter means (20) and the logarithmic-to-linear converter means (32, 33) for generating a signal representative of the amplitude of the orthogonally modulated signal received by the amplitude limiter means.

2. A digital radio receiver as claimed in claim 1, wherein the amplitude limiter means (20) comprises a series of tapped limiter amplifiers (40) for defining successive tap points, and wherein the logarithmic detector means (30) comprises a plurality of detectors (41) coupled respectively to the tap points and an adder (42) for summing outputs of the detectors to produce the amplitude representative signal.

3. A digital radio receiver as claimed in claim 2, wherein the limiter amplifiers (40) have equal values of amplification gain.

4. A digital radio receiver as claimed in claim 1, 2 or 3, wherein the equalizer means (28) is a maximum likelihood sequence estimation (MLSE) equalizer.

5. A digital radio receiver as claimed in claim 1, 2, 3 or 4, wherein the orthogonally modulated signal received by the amplitude limiter means (20) is an intermediate frequency signal, IF, and a constant-amplitude version of the received IF signal is produced by the amplitude limiter means.

6. The use of the digital radio receiver as claimed in claim 1 to receive an orthogonally modulated intermediate frequency signal, whereby the amplitude limiter means provides a constant amplitude version of the received intermediate frequency signal.

## Patentansprüche

1. Digitaler Funkempfänger mit:
einer Einrichtung (20, 21) zum Empfangen eines orthogonal modulierten Signals (IF) und Erzeugen einer modifizierten Version des Empfangssignals;
einer mit der Empfangseinrichtung gekoppelten Orthogonaldetektoreinrichtung (22) zum orthogonalen Mischen des modifizierten Signals mit einem Referenzträger und Erzeugen eines ersten Basisbandsignals (I) gleichphasig mit dem Referenzträger und eines zweiten Basisbandsignals (Q) quadraturphasig mit dem Referenzträger;
einer Analog/Digital-Wandlereinrichtung (24, 25) zum Umwandeln des ersten und zweiten Basisbandsignals in ein erstes bzw. zweites digitales Basisbandsignal;
einer mit der Empfangseinrichtung gekoppelten Logarithmus/Linear-Wandlereinrichtung (33) zum Umwandeln einer logarithmischen Teilung in eine lineare Teilung;
einer Multiplizierereinrichtung (26, 27) zum Multiplizieren des ersten und zweiten digitalen Basisbandsignals mit dem die Amplitude in linearer Teilung darstellenden Signal von der Logarithmus/Linear-Wandlereinrichtung;
einer mit der Multiplizierereinrichtung gekoppelten Entzerrereinrichtung (28) zum Entzerren des multiplizierten ersten und zweiten digitalen Basisbandsignals, um ein erstes und zweites entzerrtes Digitalsignal zu erzeugen; und
einer mit der Entzerrereinrichtung gekoppelten Demodulatoreinrichtung (29) zum Wiederherstellen eines Modulationssignals aus dem ersten und zweiten entzerrten Digitalsignal;
gekennzeichnet dadurch, daß die Empfangseinrichtung eine Amplitudenbegrenzereinrichtung (20, 21) zum Empfangen des orthogonal modulierten Signals (IF) und Erzeugen einer amplitudenstabilen Version des Empfangssignals aufweist, daß die Orthogonaldetektoreinrichtung (22) mit der Amplitudenbegrenzereinrichtung zum orthogonalen Mischen des amplitudenstabilen Signals mit dem Referenzträger gekoppelt ist, und durch eine zwischen der Amplitudenbegrenzereinrichtung (20) und der Logarithmus/Linear-Wandlereinrichtung (32, 33) gekoppelte logarithmische Detektoreinrichtung (30) zum Erzeugen eines Signals als Darstellung der Amplitude des durch die Amplitudenbegrenzereinrichtung empfangenen orthogonal modulierten Signals.

2. Digitaler Funkempfänger nach Anspruch 1, wobei die Amplitudenbegrenzereinrichtung (20) eine Reihe von Begrenzerverstärkern (40) mit Anzapfungen zum Definieren aufeinanderfolgender Anzapfpunkte aufweist und wobei die logarithmische Detektoreinrichtung (30) mehrere jeweils mit den Anzapfpunkten gekoppelte Detektoren (41) sowie einen Addierer (42) zum Summieren von Ausgaben der Detektoren aufweist, um das die Amplitude darstellende Signal zu erzeugen.

3. Digitaler Funkempfänger nach Anspruch 2, wobei die Begrenzerverstärker (40) gleiche Verstärkungswerte haben.

4. Digitaler Funkempfänger nach Anspruch 1, 2 oder 3, wobei die Entzerrereinrichtung (28) ein Entzerrer zur Abschätzung der Folge mit der größten Wahrscheinlichkeit (MLSE-Entzerrer) ist.

5. Digitaler Funkempfänger nach Anspruch 1, 2, 3 oder 4, wobei das durch die Amplitudenbegrenzereinrichtung (20) empfangene orthogonal modulierte Signal ein Zwischenfrequenzsignal (IF-Signal) ist und eine amplitudenstabile Version des empfangenen IF-Signals durch die Amplitudenbegrenzereinrichtung erzeugt wird.

6. Verwendung des digitalen Funkempfängers nach Anspruch 1 zum Empfangen eines orthogonal modulierten Zwischenfrequenzsignals, wobei die Amplitudenbegrenzereinrichtung eine amplitudenstabile Version des empfangenen Zwischenfrequenzsignals liefert.

## Revendications

1. Récepteur de radio numérique comprenant:
- un moyen (20, 21) pour recevoir un signal modulé orthogonalement (IF) et produire une version modifiée du signal reçu;
- un moyen de détecteur orthogonal (22) couplé au moyen de réception pour mélanger orthogonalement le signal modifié avec une porteuse de référence et produire un premier signal de bande de base (I) en phase avec la porteuse de référence et un second signal de bande de base (Q) en quadrature de phase avec la porteuse de référence;
- un moyen de convertisseur analogique-numérique (24, 25) pour convertir lesdits premier et second signaux de bande de base en premier et second signaux de bande de base numériques, respectivement;
- un moyen de convertisseur logarithmique-linéaire (33) couplé au moyen de réception pour convertir l'échelle logarithmique en échelle linéaire;
- un moyen de multiplicateur (26, 27) pour multiplier les premier et second signaux de bande de base numériques avec le signal représentatif de l'amplitude à l'échelle linéaire provenant du moyen de convertisseur logarithmique-linéaire;
- un moyen d'égaliseur (28) couplé au moyen de multiplicateur pour égaliser les premier et second signaux de bande de base numériques multipliés pour produire des premier et second signaux numériques égalisés; et
- un moyen de démodulateur (29) couplé au moyen d'égaliseur pour récupérer un signal de modulation au sein des premier et second signaux numériques égalisés;
caractérisé en ce que le moyen de réception comprend un moyen limiteur d'amplitude (20, 21) pour recevoir le signal modulé orthogonalement (IF) et produire une version à amplitude constante du signal reçu, en ce que le moyen de détecteur orthogonal (22) est couplé au moyen limiteur d'amplitude pour mélanger orthogonalement le signal à amplitude constante avec la porteuse de référence, et par un moyen de détecteur logarithmique (30) couplé entre le moyen limiteur d'amplitude (20) et le moyen de convertisseur logarithmique-linéaire (32, 33) pour produire un signal représentatif de l'amplitude du signal modulé orthogonalement reçu parle moyen limiteur d'amplitude.

2. Récepteur de radio numérique selon la revendication 1, dans lequel le moyen limiteur d'amplitude (20) comprend une série d'amplificateurs limiteurs à prise (40) pour définir des points de prise successifs, et dans lequel le moyen de détecteur logarithmique (30) comprend une multitude de détecteur (41) couplés respectivement aux points de prise et un additionneur (42) pour effectuer la sommation des sorties des détecteurs et produire le signal représentatif de l'amplitude.

3. Récepteur de radio numérique selon la revendication 2, dans lequel les amplificateurs limiteurs (40) ont des valeurs égales du gain d'amplification.

4. Récepteur de radio numérique selon la revendication 1, 2 ou 3, dans lequel le moyen d'égaliseur (28) est un égaliseur à estimation de la séquence probable maximale (MLSE).

5. Récepteur de radio numérique selon la revendication 1, 2, 3 ou 4, dans lequel le signal modulé orthogonalement reçu par le moyen limiteur d'amplitude (20) est un signal de fréquence intermédiaire (IF), et une version à amplitude constante du signal IF reçu est produite par le moyen limiteur d'amplitude.

6. Utilisation du récepteur de radio numérique selon la revendication 1, pour recevoir un signal de fréquence intermédiaire modulé orthogonalement, grâce à quoi le moyen limiteur d'amplitude fournit une version à amplitude constante du signal de fréquence intermédiaire reçu.
